Europäisches Patentamt

European Patent Office

Office européen des brevets

(11) Veröffentlichungsnummer : **0 428 787 B1**

(12) **EUROPÄISCHE PATENTSCHRIFT**

(45) Veröffentlichungstag der Patentschrift :
**16.09.92 Patentblatt 92/38**

(51) Int. Cl.⁵ : **C23C 8/36,** C23C 8/22,
C21D 1/773, H01J 37/32

(21) Anmeldenummer : **89121763.0**

(22) Anmeldetag : **24.11.89**

(54) Industrievakuumofen.

(43) Veröffentlichungstag der Anmeldung :
**29.05.91 Patentblatt 91/22**

(45) Bekanntmachung des Hinweises auf die
Patenterteilung :
**16.09.92 Patentblatt 92/38**

(84) Benannte Vertragsstaaten :
**CH DE FR GB IT LI NL SE**

(56) Entgegenhaltungen :
**FR-A- 2 264 891**
**US-A- 4 760 584**

(73) Patentinhaber : **IPSEN INDUSTRIES
INTERNATIONAL GESELLSCHAFT MIT
BESCHRÄNKTER HAFTUNG
Flutstrasse 52
W-4190 Kleve 1 (DE)**

(72) Erfinder : **Law, Trevor
65 Rooks Street
Cottenham/Cambridge (GB)**
Erfinder : **Andrews, Richard
6 Wainsfield Villas
Thaxted/Essex (GB)**
Erfinder : **Gall, Christopher
102 Sheffield Court
Chalfont, Pennsylvania 18914 (US)**

(74) Vertreter : **Patentanwälte Dipl.-Ing. Alex
Stenger Dipl.-Ing. Wolfram Watzke Dipl.-Ing.
Heinz J. Ring
Kaiser-Friedrich-Ring 70
W-4000 Düsseldorf 11 (DE)**

**Beschreibung**

Die Erfindung betrifft einen Industrievakuumofen für die Plasmaaufkohlung metallischer Werkstücke mittels eines kohlenstoffhaltigen Gases mit einem bezüglich der anodischen Ofenwand elektrisch isolierten, kathodischen Chargenträger.

Industrievakuumöfen für die Plasmaaufkohlung metallischer Werkstücke mittels eines kohlenstoffhaltigen Gases, beispielsweise Methan oder Propan, sind bekannt. Der Prozeß der Plasmaaufkohlung macht es erforderlich, die Charge in dem Vakuumofen auf eine Temperatur zwischen 850 und 1000°C zu erhitzen. Darüber hinaus muß die Charge auf ein hohes negatives Potential bezüglich der Ofenkammer gelegt werden, wobei sich diese Ofenkammer üblicherweise auf Erdpotential befindet. Eine das kohlenstoffhaltige Gas für die Plasmaaufkohlung enthaltene Gasmischung strömt durch den Ofen, wobei das kohlenstoffhaltige Gas durch den Einfluß des elektrischen Feldes ionisiert wird. Dabei setzen sich die positiven Kohlenstoff-Ionen auf der kathodischen, also negativ geladenen Charge ab.

Zur Schaffung eines elektrischen Potentials zwischen der Charge und der Ofenwand ist es wesentlich, daß die Charge von der Ofenwand elektrisch isoliert ist, um so einen Kurzschluß zu verhindern. Zu diesem Zweck ist der Vakuumofen mit kathodischen Chargenträgern ausgestattet, die die Charge von der anodischen Ofenwand elektrisch isolieren. Diese kathodischen Chargenträger dienen der Aufnahme der metallischen Chargen, wobei zu diesem Zweck Graphitschienen vorgesehen sein können, die einen Herd bilden, auf dem die Chargen gelagert sind derart, daß sie das gleiche elektrische Potential aufweisen wie die kathodischen Chargenträger.

Während der Plasmaaufkohlung lagert sich Kohlenstoffruß durch den Methan- oder Propanzerfall auf der Oberfläche der keramischen Isolatoren ab, die den kathodischen Chargenträger von der anodischen Ofenwand elektrisch isolieren. Unter Umständen sind die Rußablagerungen derart groß, daß sich zwischen der Kathode und der Anode auf der Oberfläche des elektrischen Isolators eine Kurzschlußstrecke bildet, die die beiden Elektroden kurzschließt, was zum Ausfall des Industrievakuumofens führt, so daß dieser zunächst gereinigt und die Rußablagerungen entfernt werden müssen.

Davon ausgehend liegt der Erfindung die **Aufgabe** zugrunde, einen Industrievakuumofen für die Plasmaaufkohlung metallischer Werkstücke mittels eines kohlenstoffhaltigen Gases zu schaffen, bei dem Kurzschlüsse verursachende Rußablagerungen auf der Oberfläche des elektrischen Isolators vermieden werden.

Als technische **Lösung** wird mit der Erfindung vorgeschlagen, daß die Oberfläche des elektrischen Isolators für den kathodischen Chargenträger gegenüber der anodischen Ofenwand im Bereich einer durch Kohlenstoffablagerungen möglichen Kurzschlußstrecke zwischen Kathode und Anode durch ein das Vordringen des kohlenstoffhaltigen Gases verhinderndes, inertes Spülgas zum Unterbrechen dieser Kurzschlußstrecke zumindest teilweise spülbar ist.

Durch das Spülen der Oberfläche des elektrischen Isolators wird auf mechanische Weise das Vordringen des kohlenstoffhaltigen Gases für die Plasmaaufkohlung zu den keramischen Isolatoren des kathodischen Chargenträgers durch einen ausreichend starken Gegenstrom des inerten Spülgases verhindert. Das Spülgas fließt dabei durch die Gasspülung über die Oberfläche des keramischen Isolators und bildet dabei gewissermaßen eine Schutzschicht gegenüber dem kohlenstoffhaltigen Gas für die Plasmaaufkohlung, so daß sich kein Ruß auf der Oberfläche der keramischen Isolatoren absetzen kann. Sollte sich dabei bereits Ruß auf der Oberfläche der keramischen Isolatoren abgesetzt haben, so erfolgt eine Reinigung durch Freiblasen der sich bereits abgesetzten Rußteilchen und beseitigt diese. Ein derartiger Reinigungsvorgang durch Freiblasen kann in zeitlich regelmäßigen Abständen erfolgen, falls nicht eine kontinuierliche Gasspülung vorgenommen wird, die von vornherein ein Absetzen von Rußteilchen auf der Oberfläche des elektrischen Isolators verhindert, so daß ein Freiblasen erst gar nicht erforderlich ist.

Vorzugsweise ist als inertes Spülgas Argon, Wasserstoff oder Helium vorgesehen. Bevorzugt wird dabei Wasserstoff, da dieser die Plasmabildung unterdrückt und daher von vornherein die Bildung von Ruß verhindert.

In einer Weiterbildung ist der kathodische Chargenträger vorzugsweise durch einen Kathodenstab gebildet, zwischen dem und der Ofenwand der elektrische Isolator angeordnet ist, welcher von einer Buchse umgeben ist, die insbesondere im Übergangsbereich zwischen dem elektrischen Isolator und dem Kathodenstab einen Ringspalt für das Spülgas bildet, wobei in diesem Ringspalt eine Spülgaszuleitung mündet. Durch die Ausbildung eines derartigen Ringspaltes wird nicht nur eine mögliche Kurzschlußstrecke um den gesamten Umfang um den elektrischen Isolator herum unterbrochen, sondern es werden vor allem auch nur sehr geringe Spülgasmengen in diesem umspülten Bereich des elektrischen Isolators benötigt. Dadurch wird eine effektive Spülung der Oberfläche des elektrischen Isolators zur Verhinderung eines Kurzschlusses erzielt.

Die Buchse kann aus Metall oder aber vorzugsweise aus einem elektrischen Isolationsmaterial, insbesondere aus einem keramischen Material, bestehen. Selbstverständlich ist das Material darüber hinaus wärmebeständig.

2

Wenn die Buchse in einer Weiterbildung wenigstens eine außen umlaufende Rippe aufweist, wobei vorzugsweise mehrere derartige Rippen vorgesehen sind, wird dadurch die Ausbildung eines Kurzschlußweges aus sich auf der Außenseite der Buchse absetzendem Ruß verhindert.

In einer Weiterbildung wird vorgeschlagen, daß der Kathodenstab von einem Rohr mit Abstand umgeben ist, wobei das inerte Spülgas durch den zwischen Kathodenstab und Rohr definierten Ringspalt geleitet ist. Handelt es sich bei dem Rohr vorzugsweise um ein Rohr aus Graphit oder dgl., bildet es ein elektrisches Pufferpotential bezüglich zum Kathodenstab und verhindert somit die Ausbildung einer Glimmentladung auf diesem und damit die Gefahr einer kurzschlußbildenden Brückenbildung durch sich ablagernden Ruß. Handelt es sich bei dem Rohr um ein neutrales Rohr, so wirkt dieses als Schutzrohr und verhindert die Ablagerung von Ruß auf dem Kathodenstab bei Betrieb des Ofens.

Vorzugsweise weist dabei der Kathodenstab eine den Ringspalt zwischen dem Kathodenstab und dem Rohr abdeckende Schutzkappe auf. Diese Schutzkappe verhindert ein Verschmutzen des Ringspaltes zwischen dem Kathodenstab und dem Rohr durch hineinfallenden Ruß und damit das Auftreten eines Kurzschlusses. Die Schutzkappe weist dabei einen größeren Durchmesser als der Durchmesser des Rohres auf und ist vorzugsweise als auf den Kopf gestellter Becher ausgebildet.

Zwei Ausführungsbeispiele eines erfindungsgemäßen Industrievakuumofens für die Plasmaaufkohlung metallischer Werkstücke mittels eines kohlenstoffhaltigen Gases werden nachfolgend anhand der schematischen Zeichnungen beschrieben. In diesen zeigt:

Fig. 1 eine geschnittene Teilansicht des Vakuumofens im Bereich eines Chargenträgers in einer ersten Ausführungsform;

Fig. 2 eine entsprechende Darstellung einer zweiten Ausführungsform

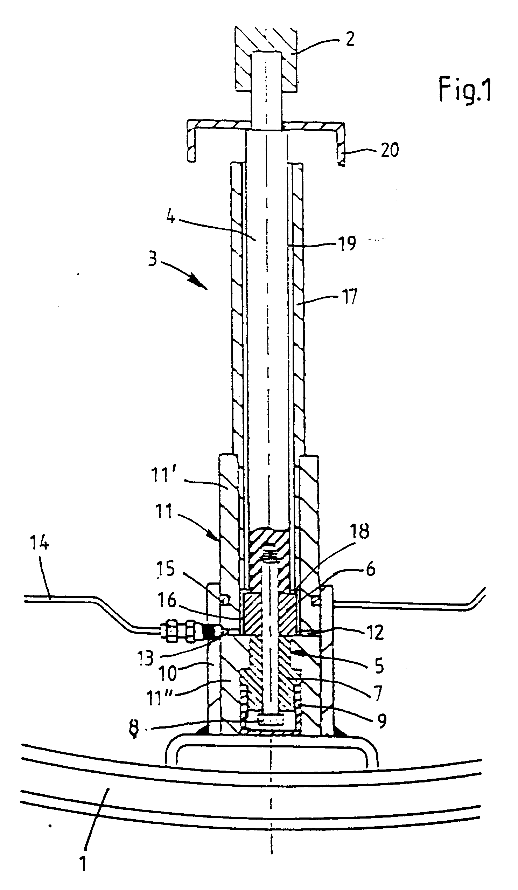

Der Industrievakuumofen in Fig. 1 weist eine doppelwandige, wassergekühlte Ofenwand 1 auf. Diese liegt auf Erdpotential und bildet die Anode des Systems für die Plasmaaufkohlung. Durch die Ofenwand 1 ist an einer nicht dargestellten Stelle die Zuführung für das kohlenstoffhaltige Gas für die Plasmaaufkohlung geführt.

Innerhalb des Ofens ist ein Herd für die zu behandelnden metallischen Werkstücke angeordnet. Dieser Herd und damit die aufliegenden metallischen Werkstücke liegen auf einem hohen negativen Potential, welches die Kathode des Systems für die Plasmaaufkohlung bildet. Zu diesem Zweck sind im Ofen drei zueinander parallele Schienen 2 aus Graphit angeordnet, wobei in der Zeichnung jedoch nur eine dieser drei Schienen 2 dargestellt ist. Jede dieser Schienen 2 wird durch kathodische Chargenträger 3 getragen. Im Normalfall sind drei dieser Chargenträger 3 für jede Schiene 2 vorgesehen.

Der kathodische Chargenträger 3 stützt sich auf dem Boden der anodischen Ofenwand 1 ab und besteht grundsätzlich aus einem senkrecht nach oben sich erstreckenden Kathodenstab 4 aus Metall sowie aus einem elektrischen Isolator 5 zur elektrischen Isolation des Kathodenstabes 4 gegenüber der anodischen Ofenwand 1.

Der metallische Kathodenstab 4 ruht auf im wesentlichen zylinderförmigen, keramischen Stützscheiben 6 und 7. Diese bilden den elektrischen Isolator 5, der den Kathodenstab 4 gegenüber der anodischen Ofenwand 1 elektrisch isoliert. Zusammgehalten werden der Kathodenstab mit den keramischen Stützscheiben 6 und 7 durch eine metallische Schraube 8. Um diese ebenfalls auf einem negativen Potential liegende Schraube 8 gegenüber der anodischen Ofenwand 1 abzuschirmen, ist weiterhin eine keramische Schutzkappe 9 als weiteres Element des elektrischen Isolators 5 vorgesehen.

Der Kathodenstab 4 mit dem elektrischen Isolator 5 wird durch eine Befestigungshülse 1O an der Ofenwand 1 gehalten. Diese Befestigungshülse 1O ist dabei mit dem Boden der Ofenwand 1 verschweißt. Zwischen der Befestigungshülse 1O und der Einheit aus Kathodenstab 4 und elektrischem Isolator 5 ist eine Buchse 11 angeordnet, welche in diesem Ausführungsbeispiel aus zwei Buchsenteilen 11′, 11″ besteht. Diese sind ebenfalls zylinderförmig ausgebildet und bestehen entweder aus Metall oder vorzugsweise - wie im Ausführungsbeispiel - aus einem Isolationsmaterial, beispielsweise aus einem keramischen Material. Zwischen dem oberen Buchsenteil 11′ und dem unteren Buchsenteil 11″ der Buchse 11 ist ein Ring 12 angeordnet, welcher auf der Ober- und/oder Unterseite radial verlaufende Kerben aufweist. Zusammen mit der Befestigungshülse 1O sowie mit den beiden Buchsenteilen 11′, 11″ definiert der Ring 12 einen umlaufenden Ringkanal 13. In diesem mündet eine durch die Befestigungshülse 1O hindurchgeführte Spülgaszuleitung 14 für ein inertes Spülgas, welches insbesondere durch Wasserstoff gebildet ist. Zwischen der Befestigungshülse 1O und dem oberen Buchsenteil 11′ ist eine O-Ring-Dichtung 15 angeordnet. Wie in Fig. 1 erkennbar ist, ist zwischen dem oberen Buchsenteil 11′ und der keramischen Stützscheibe 6 des elektrischen Isolators 5 ein zylindrischer Ringspalt 16 freigelassen, der mit dem Ringkanal 13 über die radial verlaufenden Kerben im Ring 12 in Verbindung steht.

Auf das obere Buchsenteil 11′ der Buchse 11 ist ein Rohr 17 aus Graphit aufgesteckt. Das untere Ende dieses Rohres 17 endet dabei mit etwas Abstand über der oberen Stirnfläche der keramischen Stützscheibe 6 und definiert dabei einen Ringspalt 18. Da das Rohr 17 den Kathodenstab 4 mit Abstand konzentrisch umgibt, ist dadurch zwischen dem Kathodenstab 4 und dem Rohr 17 ebenfalls ein Ringspalt 19 definiert, welcher sich an den Ringspalt 18 anschließt. Oberhalb des Rohres 17 ist am Kathodenstab 4 noch eine Schutzkappe 2O angeordnet, welche als umgedrehter Becher ausgebildet ist und dabei einen Durchmesser aufweist, der größer ist als der Durchmesser des Rohres 17 und somit den Ringspalt 19 abdeckt.

Die Funktionsweise dieses so ausgebildeten gasgespülten kathodischen Chargenträgers 3 für die Plasmaaufkohlung metallischer Werkstücke gemäß Fig. 1 ist wie folgt:

Der Ofen wird mit einem kohlenstoffhaltigen Gas für die Plasmaaufkohlung gefüllt und auf 85O bis 1OOO°C erhitzt. An den Kathodenstab 4 wird ein hohes negatives Potential gelegt. Da dieser mit der Schiene 2 aus Graphit elektrisch verbunden ist und da die metallischen Werkstücke auf der Schiene 2 aufliegen und dadurch ebenfalls eine elektrische Verbindung hergestellt ist, liegen die zu behandelnden metallischen Werkstücke ebenfalls auf dem hohen negativen Potential, so daß eine Plasmaaufkohlung durch elektrische Entladungen stattfinden kann.

Das durch die Spülgaszuleitung 14 zugeführte Spülgas dringt in den Ringkanal 13 ein, der durch die Befestigungshülse 1O und die beiden Buchsenteile 11′ und 11″ gebildet ist, und verteilt sich in diesem Ringkanal 13. Durch die radialen Kerben im Ring 12 dringt das Spülgas ins Innere in den Ringspalt 16 zwischen der keramischen Stützscheibe 6 und dem oberen Buchsenteil 11′ und steigt von dort aus nach Passieren des Ringspaltes 18 nach oben durch den Ringspalt 19 zwischen dem Kathodenstab 4 und dem Rohr 17. Die O-Ring-Dichtung 15 verhindert das Austreten des Spülgases, während das aus Graphit bestehende Rohr 17 die Ausbildung einer Glimmentladung auf dem Kathodenstab 4 verhindert, da es ein bezüglich zum Kathodenstabpotential auf einem Pufferpotential liegt. Die Schutzkappe 2O verhindert die Verschmutzung des Ringspaltes 19 zwischen dem Kathodenstab 4 und dem Rohr 17 und damit das Auftreten eines Kurzschlusses dadurch, daß kein Ruß in den Ringspalt 19 fallen kann.

Das Spülgas umströmt somit die Oberfläche des elektrischen Isolators 5 im Bereich der oberen keramischen Stützscheibe 6 und verhindert somit auf rein mechanische Weise das Vordringen des kohlenstoffhaltigen Gases für die Plasmaaufkohlung, indem das Spülgas einen ausreichend starken Gegenstrom bildet. Dabei wird verhindert, daß sich auf der Oberfläche des elektrischen Isolators 5 Kohlenstoffruß absetzt, der durch Methan- und Propanzerfall entstehen kann. Auf diese Weise wird ein Leitendmachen der Oberfläche des elektrischen Isolators 5 und damit eine Kurzschlußgefahr unterbunden.

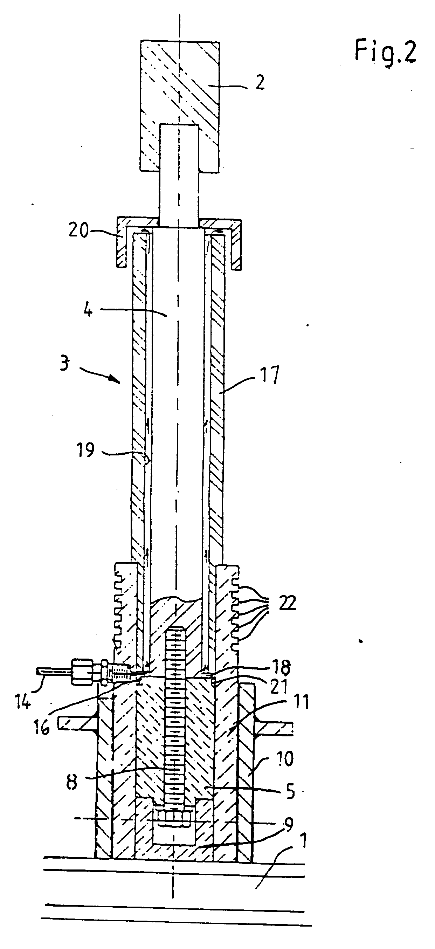

Die Ausführungsform gemäß Fig. 2 unterscheidet sich von der ersten Ausführungsform in Fig. 1 im wesentlichen dadurch, daß der elektrische Isolator 5 und die Buchse 11 jeweils einstückig ausgebildet sind. Ein weiterer wesentlicher Unterschied liegt in der Zuführung der Spülgaszuleitung 14 sowie vor allem in der Ausbildung des Ringspaltes 16. Wie in Fig. 2 erkennbar ist, weist das obere Ende des elektrischen Isolators 5 eine Abstufung 21 mit einer Durchmesserverringerung auf, so daß dadurch im Bereich dieser Abstufung 21 zwischen dem elektrischen Isolator 5 und der Buchse 11 der Ringspalt 16 definiert ist, oberhalb dem die durch die Buchse 11 hindurchgeführte Spülgaszuleitung 14 mündet, und zwar in der Ebene des Ringspaltes 18, welcher zwischen der unteren Stirnseite des Rohres 17 und der oberen Stirnseite des elektrischen Isolators 5 definiert ist.

Weiterhin ist in Fig. 2 erkennbar, daß bei dieser Ausführungsform das aus der Befestigungshülse 1O herausragende obere Ende der Buchse 11 umlaufende Rippen 22 aufweist, welche verhindern, daß sich ein Kurzschlußweg aus sich absetzendem Ruß auf der Außenseite der Buchse 11 bildet.

Auch bei dieser Ausführungsform tritt das Spülgas aus der Spülgaszuleitung 14 aus und verteilt sich in den winkelförmig zueinander angeordneten Ringspalten 16 und 18 und verhindert dabei, daß kohlenstoffhaltiges Gas bis zu diesem Bereich der Oberfläche des elektrischen Isolators 5 vordringt. Nach Durchlaufen der beiden Ringspalte 16 und 18 fließt dann das inerte Spülgas durch den Ringspalt 19, welcher zwischen dem Kathodenstab 4 und dem Rohr 17 ausgebildet ist.

Bezugszeichenliste

1 Ofenwand (anodisch)
2 Schiene
3 Chargenträger (kathodisch)
4 Kathodenstab
5 elektrischer Isolator
6 keramische Stützscheibe
7 keramische Stützscheibe
8 Schraube
9 keramische Schutzkappe
1O Befestigungshülse
11 Buchse

11' Buchsenteil
11" Buchsenteil
12 Ring
13 Ringkanal
14 Spülgaszuleitung
15 O-Ring-Dichtung
16 Ringspalt
17 Rohr
18 Ringspalt
19 Ringspalt
2O Schutzkappe
21 Abstufung
22 Rippe

## Patentansprüche

1. Industrievakuumofen für die Plasmaaufkohlung metallischer Werkstücke mittels eines kohlenstoffhaltigen Gases mit einem bezüglich der anodischen Ofenwand (1) elektrisch isolierten, kathodischen Chargenträger (3),
**dadurch gekennzeichnet,**
daß die Oberfläche des elektrischen Isolators (5) für den kathodischen Chargenträger (3) gegenüber der anodischen Ofenwand (1) im Bereich einer durch Kohlenstoffablagerungen möglichen Kurzschlußstrecke zwischen Kathode und Anode durch ein das Vordringen des kohlenstoffhaltigen Gases verhinderndes, inertes Spülgas zum Unterbrechen dieser Kurzschlußstrecke zumindest teilweise spülbar ist.

2. Industrievakuumofen nach Anspruch 1, dadurch gekennzeichnet, daß das inerte Spülgas Argon, Wasserstoff oder Helium ist.

3. Industrievakuumofen nach Anspruch 1 oder 2, dadurch gekennzeichnet, daß der kathodische Chargenträger (3) durch einen Kathodenstab (4) gebildet ist, zwischen dem und der Ofenwand (1) der elektrische Isolator (5) angeordnet ist, welcher von einer Buchse (11) umgeben ist, die insbesondere im Übergangsbereich zwischen dem elektrischen Isolator (5) und dem Kathodenstab (4) einen Ringspalt (16,18) für das Spülgas bildet, wobei in diesem Ringspalt (16,18) eine Spülgaszuleitung (14) mündet.

4. Industrievakuumofen nach Anspruch 3, dadurch gekennzeichnet, daß die Buchse (11) aus Metall oder aus einem elektrischen Isolationsmaterial, insbesondere aus einem keramischen Material, besteht.

5. Industrievakuumofen nach Anspruch 3 oder 4, dadurch gekennzeichnet, daß die Buchse (11) wenigstens eine außen umlaufende Rippe (22) aufweist.

6. Industrievakuumofen nach einem der Ansprüche 3 bis 5, dadurch gekennzeichnet, daß der Kathodenstab (4) von einem Rohr (17) mit Abstand umgeben ist, wobei das inerte Spülgas durch den zwischen Kathodenstab (4) und Rohr (17) definierten Ringspalt (19) geleitet ist.

7. Industrievakuumofen nach Anspruch 6, dadurch gekennzeichnet, daß das Rohr (17) aus Graphit besteht.

8. Industrievakuumofen nach Anspruch 6 oder 7, dadurch gekennzeichnet, daß der Kathodenstab (4) eine den Ringspalt (19) zwischen dem Kathodenstab (4) und dem Rohr (17) abdeckende Schutzkappe (2O) aufweist.

## Claims

1. Industrial vacuum furnace for the plasma carburization of metallic workpieces by means of a carbonaceous gas, with a cathodic charge carrier (3) which is electrically insulated with respect to the anodic furnace wall (1), characterised in that the surface of the electrical insulator (5) for the cathodic charge carrier (3) with respect to the anodic furnace wall (1) can be at least partly flushed in the area of a short-circuit path, resulting from carbon deposits, between the cathode and the anode by an inert flushing gas, which prevents the carbonaceous gas from advancing, in order to break this short-circuit path.

2. Industrial vacuum furnace according to claim 1, characterised in that the inert flushing gas is argon, hydrogen or helium.

3. Industrial vacuum furnace according to claim 1 or 2, characterised in that the cathodic charge carrier (3) is formed by a cathode rod (4), between which and the furnace wall (1) the electrical insulator (5) is arranged, which insulator is surrounded by a bushing (11) which forms an annular gap (16, 18) for the flushing gas, in particular in the transition area between the electrical insulator (5) and the cathode rod (4), a flushing gas feed conduit (14) leading into this annular gap (16, 18).

4. Industrial vacuum furnace according to claim 3, characterised in that the bushing (11) consists of metal or an electrical insulating material, in particular of a ceramic material.

5. Industrial vacuum furnace according to claim 3 or 4, characterised in that the bushing (11) comprises at least one externally circulating rib (22).

6. Industrial vacuum furnace according to one of claims 3 to 5, characterised in that the cathode rod (4) is surrounded by a tube (17) at a spacing, the inert flushing gas being conveyed through the annular gap (19) defined between the cathode rod (4) and the tube (17).

7. Industrial vacuum furnace according to claim 6, characterised in that the tube (17) consists of graphite.

8. Industrial vacuum furnace according to claim 6 or 7, characterised in that the cathode rod (4) comprises a protective cap (20) which covers the annular gap (19) between the cathode rod (4) and the tube (17).

**Revendications**

1) Four industriel sous vide pour la cémentation par plasma de pièces métalliques au moyen d'un gaz carburé, comportant un support de charges cathodique (3) isolé électriquement vis-à-vis de la paroi anodique (1) du four,
caractérisé en ce que
la surface de l'isolateur électrique (5) isolant le support de charges cathodique (3) de la paroi anodique (1) du four est, dans le domaine d'un trajet de court-circuit possible par dépôts de carbone entre la cathode et l'anode, balayée au moins en partie par un gaz de balayage inerte empêchant la pénétration du gaz carburé, pour interrompre le trajet de court-circuit.

2) Four industriel sous vide selon la revendication 1, caractérisé en ce que le gaz de balayage inerte est de l'argon, de l'hydrogène ou de l'hélium.

3) Four industriel sous vide selon la revendication 1 ou 2, caractérisé en ce que le support de charges cathodique (3) est constitué d'un barreau cathodique (4), l'isolateur électrique (5) étant disposé entre ce barreau et la paroi (1) du four, cet isolateur étant entouré par une douille (11) qui forme un intervalle annulaire (16, 18) pour le gaz de balayage, notamment dans la zone de raccordement entre l'isolateur électrique (5) et le barreau cathodique (4), une conduite de gaz de balayage (14) débouchant dans cet intervalle annulaire (16, 18).

4) Four industriel sous vide selon la revendication 3, caractérisé en ce que la douille (11) est en métal ou en un matériau électriquement isolant, notamment en un matériau céramique.

5) Four industriel sous vide selon la revendication 3 ou 4, caractérisé en ce que la douille (11) comporte au moins une nervure périphérique extérieure (22).

6) Four industriel sous vide selon l'une des revendications 3 à 5, caractérisé en ce que le barreau cathodique (4) est entouré à distance par un tube (17), le gaz de balayage inerte étant conduit dans l'intervalle annulaire (19) formé entre le barreau cathodique (4) et le tube (17).

7) Four industriel sous vide selon la revendication 6, caractérisé en ce que le tube (17) est en graphite.

8) Four industriel sous vide selon la revendication 6 ou 7, caractérisé en ce que le barreau cathodique (4) comporte un capuchon de protection (20) recouvrant l'intervalle annulaire (19) entre le barreau cathodique (4) et le tube (17).

Fig.1

Fig.2